## Europäisches Patentamt

## European Patent Office

## Office européen des brevets

(19)

(11) Publication number: **0 006 753**

**B1**

(12)

# EUROPEAN PATENT SPECIFICATION

(45) Date of publication of patent specification: **16.02.83**

(51) Int. Cl.³: **G 11 C 11/40, H 01 L 27/02**

(21) Application number: **79301234.5**

(22) Date of filing: **26.06.79**

(54) Semiconductor integrated circuit device.

(30) Priority: **30.06.78 JP 79391/78**
**29.12.78 JP 165131/78**

(43) Date of publication of application:
**09.01.80 Bulletin 80/1**

(45) Publication of the grant of the patent:
**16.02.83 Bulletin 83/7**

(84) Designated Contracting States:
**DE GB NL**

(56) References cited:
**DE - A1 - 2 713 024**
**DE - A1 - 2 734 539**
**DE - A1 - 2 756 267**

**ELECTRONICS, February 14, 1972, New York,**
**S. K. WIEDMANN et al. "Superintegrated**
**memory shares functions on diffused islands"**
**pages 83—86**

(73) Proprietor: **FUJITSU LIMITED**
**1015, Kamikodanaka Nakahara-ku**
**Kawasaki-shi Kanagawa 211 (JP)**

(72) Inventor: **Ono, Chikai**
**322, Seki, Tama-ku**
**Kawasaki-shi, Kanagawa 214 (JP)**
Inventor: **Toyoda, Kazuhiro**
**39, Sakuradai, Midori-ku**
**Yokohama-shi, Kanagawa 227 (JP)**

(74) Representative: **Abbott, Leonard Charles et al,**
**GILL JENNINGS & EVERY 53/64 Chancery Lane**
**London WC2A 1HN (GB)**

(56) References cited:
**IEEE Journal of solid-state circuits, June 1973,**
**New York**
**H. H. BERGER et al. "Write-Current Control and**
**Self-Powering in a Low-Power Memory Cell"**
**pages 232 to 233**

**IEEE Journal of solid-state circuits, Vol. SC-8,**
**Nr. 5, October 1973, New York**
**S. K. WIEDMANN, "Injection-Coupled Memory:**
**A High-Density Static Bipolar Memory" pages**
**332—337**

# Semiconductor integrated circuit device

The present invention relates to an improvement of a semiconductor integrated circuit memory device in which memory cells formed by integrated injection logic are arranged as a memory array.

Recently, a low power semiconductor memory or a high capacity semiconductor memory is used. In conventional memory cells used in a semiconductor memory, resistors are used as load impedances of flip-flop transistors which are used in the memory cells, and also, an insulation between transistors is required, so that the conventional memory cells are large in size. Therefore, a memory chip is also large in size and the density of the memory chips which are included in one wafer can not be increased, so that the cost of a semiconductor memory is expensive.

For the purpose of obtaining memory cells having small dimensions, memory cells using integrated injection logic are used.

At present, memory cells which are constituted by integrated injection logic are elements which are epochmaking, because such memory cells can be formed with high integration density. Such memory cells are disclosed, for example, in the articles "Write Current Control and Self Powering in a Low Power Memory Cell", IEEE, SSC, Jun., 1973, and "Superintegrated Memory Shares Functions on Diffused Islands", Electronics, Feb. 14, 1972, p83—p86. The former discloses a method of controlling a write current to the integrated injection logic memory cell and the latter discloses a basic idea with respect to the integrated injection logic memory cell.

As disclosed in the above mentioned articles, the integrated injection logic memory cell comprises a pair of first and second transistors which have emitters forming an injector which is connected to a word line W+, and said first and second transistors have a first polarity, a pair of third and fourth transistors which have a collector connected to a collector of the first or second transistors a base of the third transistor which is connected to the collector of said fourth transistor and a base of the fourth transistor which is connected to the collector of said third transistor, and both of which have a second polarity, and a bulk that is a word line W— which is connected to the bases of the first and second transistors and to emitters of the third and fourth transistors.

The integrated injection logic memory cells are arranged as the memory array. In these integrated injection logic memory cells, the word line W— is formed as the bulk, as already mentioned, and this bulk consists of two n types, an epitaxial layer and a buried layer. The epitaxial layer is formed on the buried layer which has a higher density of the impurity then the epitaxial layer. Therefore, the bulk, that is, the word line W— has a larger resistance than a metallic wire, and this resistance exists between each cell.

When the bulk is used as the word line W— which supplies the hold current, the characteristics of the cells are different in accordance with the positions of the cells in the line of the array.

That is, the following problems are caused in the memory device in which memory cells formed by integrated injection logic are arranged as a memory array.

(a) Deviation of a hold current

As a word line W—, which is provided for supplying a hold current $I_H$ to each cell, has a resistance, the hold current which is supplied to the cell positioned farthest from the hold current supply transistor is small. The value of the hold current $I_H$ should be suffucent value for keeping the hold current of the cell which is at the most remote position from the hold current supply transistor. Therefore, the excess hold current is supplied to the cells positioned near the hold current supply transistor, so that excess power is dissipated in the memory device. Further, in accordance with the deviation of the hold current of the cell, write characteristics of the cells are dependent on the position of the cells, because it is well known that a write threshold current to the cell is proportional to the injector current to the cell. The large injector current is supplied to the cell where the large hold current is supplied. Therefore, the write threshold current of the cell near the hold current supply transistor increases.

(b) The write threshold current to the cell near the end of the memory array increases

Even if there were no deviation of the hold current illustrated in above item (a), the write threshold current to the cell near the end of the memory array would increase, because during writing some current flows also to non-selected cells. Because of the word line resistance, the amount of write current thus shunted to the non-selected cells depends on the number of such cells and the distance they are located along the word lines from the selected cell. When the selected cell is at the end of the word lines the non-selected cells all lie to one side of it and the amount of the current shunted to the non-selected cells is a minimum; therefore the current which flows in the selected cell as the injector current is a maximum and the amount of the write threshold current increases.

When we assume that the write current is constant, the increase of the write threshold current illustrated in the itmes (a) and (b) above results in an increase of the width of the minimum write pulse. The increase of the write threshold current and the width of the write pulse requires excess electrical power and also deteriorates the characteristics of the cells which are used as the random access memory.

An object of the present invention is to equalize the characteristics of the integrated injection logic memory cells which are arranged as a memory array.

According to the present invention, a semiconductor integrated circuit device includes a memory cell array which is formed by integrated injection logic memory cells arranged in rows each having a pair of word lines crossed by pairs of bit lines, the integrated injection logic memory cells each receiving a hold current via the word lines and comprising a pair of first and second transistors of a first conduction type which have a common emitter forming an injector; a pair of third and fourth transistors of a second conduction type each of which has a collector connected to a collector of the first and second transistors respectively, the injector being connected to the first of a pair of word lines the third transistor having a base which is connected to the collector of the fourth transistor, the fourth transistor having base which is connected to the collector of the third transistor, and the first and second transistors having bases which are connected to emitters of the third and fourth transistors and to the second of the pair of word lines; a pair of fifth and sixth transistors of the second conduction type which have bases connected to the bases of the third and fourth transistors respectively and which have collectors connected to the second of the pair of word lines, the fifth and sixth transistors having emitters connected to the first and second of a pair of bit lines respectively; and is characterised in that dummy cells are connected between the pair of word lines in each row, each dummy cell having a shunt portion which shunts part of the write current when a memory cell in its row is written into, the amount of current shunted being greatest when the memory cell written into is immediately adjacent the dummy cell, and further having a current supply transistor which supplies a part of the hold current to the memory cells of the row, the dummy cells thus reducing the dependency of the magnitude of the write and hold currents in a memory cell on its position in a row.

A device embodying the present invention can be arranged to prevent the increase in write threshold current and write pulse width which otherwise occur when a memory cell array is formed by integrated injection logic memory cells; and to equalize the hold current to each cell and prevent increase of write threshold current without decreasing integration density.

One embodiment of the invention will be described with reference to the accompanying drawings, in which:—

Figures 1A, 1B and 1C illustrate equivalent circuits of a memory cell corresponding to one bit of a memory array formed by an integrated injection logic memory cell:

Figure 2 in a section of the memory array;

Figure 3 illustrates an array which forms n bits by using the integrated injection logic memory cells and which includes a hold circuit at one end of the word line;

Figs. 4A and 4B illustrate a plan view and a cross sectional view of the array shown in Fig. 3 (the illustrated arrangement does not form part of the present invention);

Figs. 5A, 5B and 5C illustrate semiconductor integrated circuit apparatus (the illustrated arrangements do not form part of the present invention)

Figs. 6A, 6B and 6C illustrate patterns of dummy cells which are proposed for the purpose of preventing the increase of the write threshold current in the arrays shown in Figs. 5A and 5C; these dummy cells do not include a hold current source, and therefore do not form part of the present invention;

Figs. 7A, 7B, 7C and 7D illustrate patterns of the dummy cell which are proposed in the present invention;

Figs. 8A and 8B illustrate the arrangement and the equivalent circuit of one embodiment of the array according to the present invention;

Figs. 9A and 9B illustrate patterns of essential portions of the arrays which are formed by using the dummy cells shown in Figs. 7A and 7B;

Fig. 10 illustrates an equivalent circuit of one embodiment according to the present invention; and

Figs. 11A and 11B illustrate patterns of the array of the embodiment shown in Fig. 10.

Detailed Explanation of the Invention

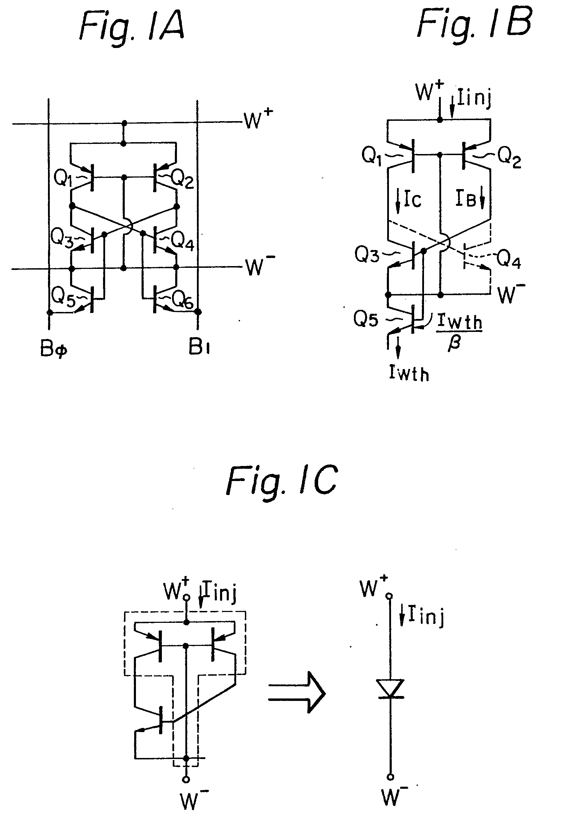

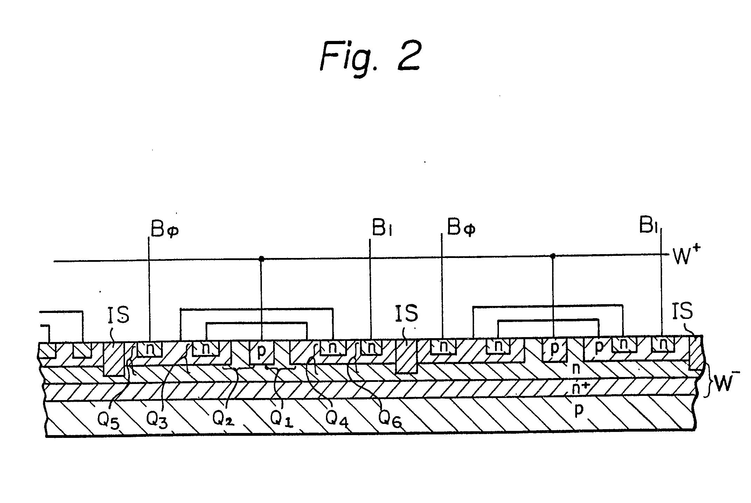

Fig. 1A is an illustration of an equivalent circuit corresponding to one memory cell which is formed by integrated injection logic. In Fig. 1A, $Q_1$ through $Q_6$ designate transistors, W+ and W− designate word lines and $B_1$, $B_{\varphi}$ designated bit lines, respectively. Fig. 2 illustrates a cross sectional view of the memory array formed by the integrated memory cells shown in Fig. 1. In Fig. 2, symbols which are the same as in Fig. 1 designate corresponding parts to those illustrated in Fig. 1.

Referring to Figs. 1A and 2, a p type conduction region which is connected to the word line W+ is an injector, and the p type conduction region is actuated as common emitters of lateral pnp transistors $Q_1$, $Q_2$. This is understood when Fig. 2 is compared with Fig. 1A. As illustrated in Figs. 1A and 2, the transistors $Q_1$ and $Q_2$ are used as loads, the usual collector regions connected to a word line W− of npn transistors $Q_3$ and $Q_4$ are used as emitters and the usual emitter regions of npn transistors $Q_3$ and $Q_4$ are used as collectors. Therefore, a bulk, that is an n type conduction region, which is commonly used as the bases of the pnp transistors $Q_1$, $Q_2$ and as the emitters of the npn transistors $Q_3$, $Q_4$, can be used as a buried word line W−, so that the cells can be formed in a high density.

Referring to the memory cell shown in Fig. 1A, transistors $Q_3$ and $Q_4$ are placed in the on and off state alternately. When the transistors $Q_3$ is placed in the on state, the transistor $Q_4$ is placed in the off state. Fig. 1B illustrates an equivalent circuit of Fig. 1A when the transistor $Q_3$ is placed in the on state. An injection current Iinj supplies a base current of an on state transistors $Q_3$. In order to change the cell information, the on state transistor $Q_3$ should be changed to an off state. This is done by supplying an emitter current larger than the write threshold current Iwth to the transistor $Q_5$ and bypassing the base current of the transistor $Q_3$ to the base current of the transistor $Q_5$.

As the base current of the transistor $Q_3$ depends on the injector current Iinj supplied to the injector, the write threshold current Iwth also depends on the injector current Iinj. Therefore, in the conventional memory cells, the write threshold current is large in the cell where the injector current is large.

Fig. 1C shows that a memory cell which is not selected is equivalent to a diode.

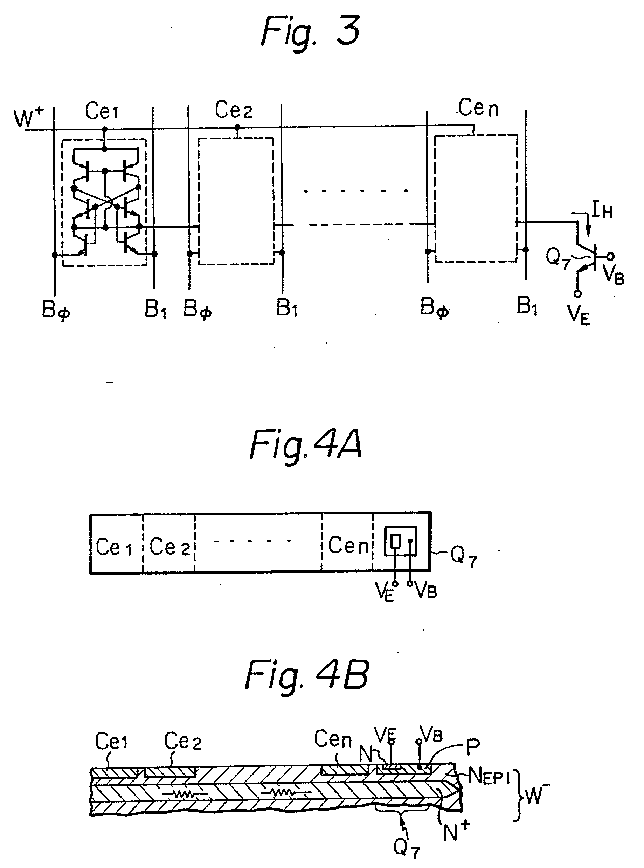

Fig. 3 illustrates one line of a memory array which forms n bits by using the memory cells illustrated in Figs. 1A and 2. Referring to Fig. 3, $Ce_1$, $Ce_2$, ..., $Ce_n$ designate a first, a second, ..., and n'th cell, respectively. Therefore, the cell array shown in Fig. 3 forms an n bits cell array. A transistor $Q_7$ is provided for supplying hold currents to the cells $Ce_1$, $Ce_2$, ..., $Ce_n$ in the array. It is understood that this hold current supply transistor $Q_7$ is integrated in a common "n" type conduction region which forms the word line W—; that is the hold current supply source. Fig. 4A illustrates a plan view of the memory array shown in Fig. 3, and Fig. 4B illustrates a cross sectional view of the memory array shown in Fig. 3. The arrangement shown in Figures 4A and 4B, though believed to be novel, does not form part of the present invention. In Figs. 3, 4A and 4B, the symbol $V_E$ illustrates an emitter terminal, the symbol $V_b$ illustrates a base terminal.

In the memory array shown in Figs. 3, 4A and 4B, the word line W— is formed by the semiconductor bulk, as already described, and this semiconductor bulk consists of two n type layers, an epitaxial layer and a buried layer. The epitaxial layer is formed on the buried layer which has a higher density of impurity than the epitaxial layer. Therefore, the word line W— has a larger resistance than a metallic layer. This resistance is due to the bulk resistance and causes the problems of deviation of the hold current and the increase of the write threshold current to the cell near the end of the memory array.

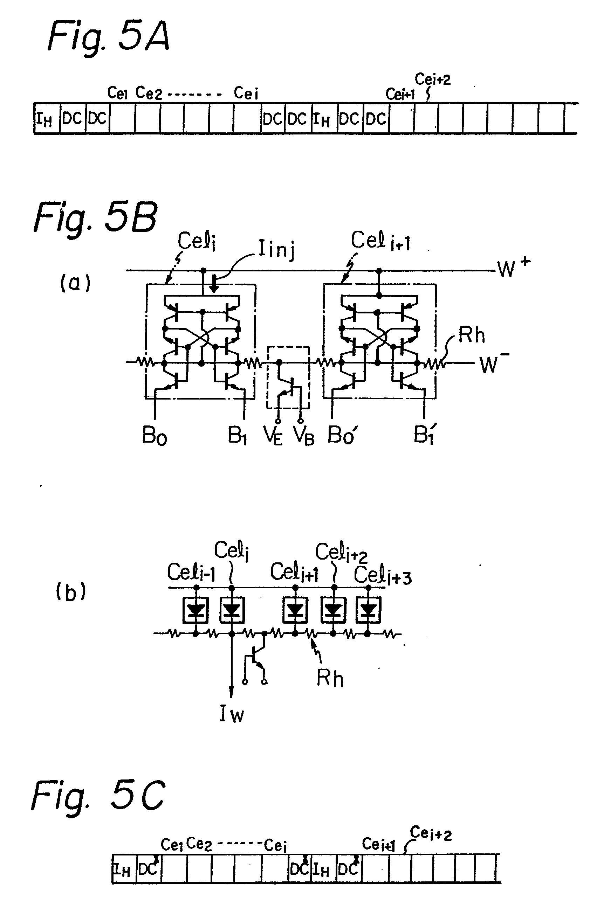

For the purpose of resolving the above-mentioned problems one array arrangement which we have proposed is shown in Fig. 5A; this however does not form part of the present invention. In the array shown in Fig. 5A, the n cells $Ce_1$, $Ce_2$, ..., $Ce_i$, $Ce_{i+1}$, $Ce_{i+2}$, ..., $Ce_n$ are arranged as a memory array, the hold current supply transistors $I_H$ are distributed so as to equalize the distribution of the hold current and dummy cells DC are distributed at both ends of the series of cells $Ce_1$, ..., $Ce_i$ so as to shunt the injector current supplied to the cell at the end of the cell array. In the circuit shown in Fig. 5A, at least one dummy cell is required; however, two or more than two dummy cells are required for the purpose of sufficiently compensating for the end effect of the memory cell. It is understood that the dummy cells have to be provided at both sides of the hold current supply transistors which are distributed in the line of the memory array, because the boundary condition is different in the cells positioned at either end of the hold current supply transistors. For example, in the circuit shown in Fig. 5B in which no dummy cells are provided at both sides of the hold current supply transistors, when the write current is supplied to the memory cell $Cel_{(i)}$ or $Cel_{(i+1)}$, the write current is not shunted to the hold current transistor and therefore the write current concentrates in the memory cell $Cel_{(i)}$ or $Cel_{(i+1)}$ so that the injector current of this cell increases and also the write threshold current of this cell increases. When more than two dummy cells are required, the plurality of the dummy cells can be replaced by one dummy cell DC* as shown in Fig. 5C by increasing the injector area of the dummy cell so as to increase the shunt current. When the dummy cells DC* shown in Fig. 5C are used, and the hold current sources are distributed at "m" positions, the number of the dummy cells required for forming the array as shown in Fig. 5C is 2m—2 because each end of the line of the array requires one dummy cell, and each side of each hold current source also requires one dummy cell. When the capacity of the memory increases, the number of the bits increases, the total amount of the resistance $R_H$ increases, the deviation of the hold current $I_H$ also increases, and therefore the number "m" has to be increased. Therefore, when the memory cell array has a large capacity, the area of the chip increases so that the integration density decreases.

In the present invention, the integration density is increased by forming the hold current source and the dummy cell as one body. The present invention is based on the following reason. In the dummy cell, the rewrite or the read out of the information is not carried out as in the memory cell; therefore, for example, the transistors $Q_5$ or $Q_6$ shown in Fig. 1A are not necessary. Also, in the dummy cell, the content of the cell is not questioned; therefore the transistors $Q_3$ and $Q_4$ for holding the information as shown in Fig. 1A are also not necessary. Therefore, the hold current supply transistor $Q_7$ can be formed in the dummy cell by removing the transistors $Q_3$, $Q_4$, $Q_5$ and $Q_6$. Even if the hold current supply transistor $Q_7$ is formed in the dummy cell as illustrated above, the characteristic of the dummy cell between the word lines W+ and W— is equivalent to one bit cell for the shunt of the write current.

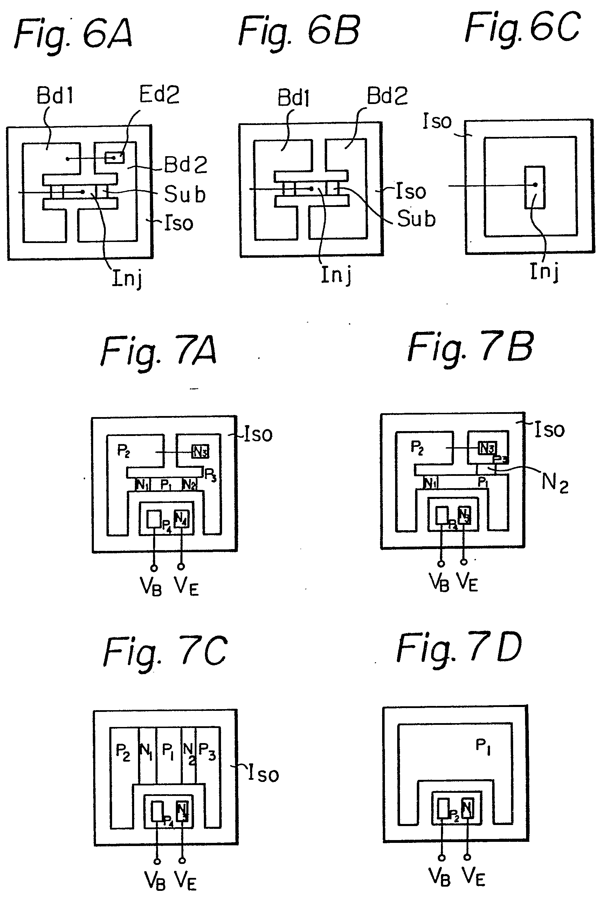

Figs. 6A, 6B and 6C illustrate a plan view of the patterns of dummy cells (without hold current sources). Referring to Figs. 6A, 6B and 6C, portions of the region Iso illustrate a passive isolation region, Iinj illustrates an injector region, $Bd_1$, $Bd_2$ illustrate "p" type base regions in the dummy cell, $Ed_2$ illustrates an "n" type emitter region in the dummy cell and Sub illustrates an exposed surface of the n type substrate.

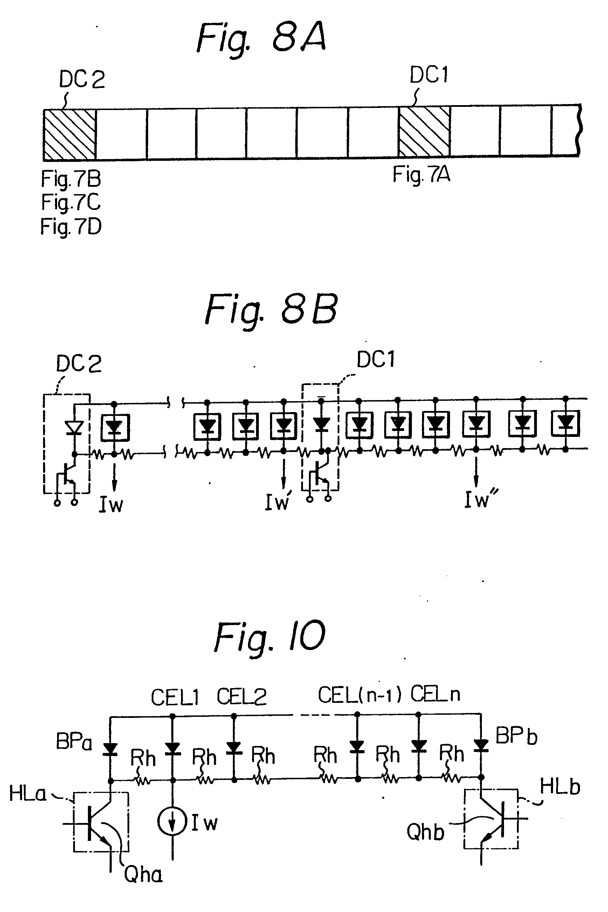

In the present invention, the hold current supply transistor is formed in the dummy cell as illustrated in Figs. 7A, 7B, 7C and 7D. In Fig. 7A, a pattern of the hold current supply transistor is formed in a part of the dummy cell shown in Fig. 6A. An injector area of the PNP transistors $P_1$—$N_1$—$P_2$ and $P_1$—$N_2$—$P_3$ can be enlarged so that the number of the dummy cells can be decreased if the write current in the adjacent cell can be sufficiently shunted. In Fig. 7B and Fig. 7C, the construction of the PNP transistor is simple; therefore the injector area can be enlarged and the dummy cell can be formed with a small dimension. In Fig. 7D, the injector region is formed by only a diode, the construction of the dunny cell can be formed with a small dimension. In Fig. 7D, the injector region is formed by only a diode, the construction of the dummy cell is very simple and the injector area can be further enlarged and the dummy cell can be formed with a small dimension when the large injector area is not necessary.

Figs. 8A and 8B illustrate the plan of the array and the equivalent circuit of the array which is formed by using the memory cells shown in Figs. 7A, 7B, 7C and 7D. Referring to Fig. 8A, a dummy cell $DC_1$ which is positioned in the midst of the array is formed by using the dummy cell shown in Fig. 7A; and a dummy cell $DC_2$ which is positioned at an end of the array is formed by using the dummy cell shown in Figs. 7B, 7C or 7D. This is because the shunt effect of the dummy cell $DC_1$ is the same as the usual memory cell at both sides of the dummy cell $DC_1$. It is preferable that the dummy cell $DC_2$ has a large injector having a larger shunt effect of the write current than the usual memory cell.

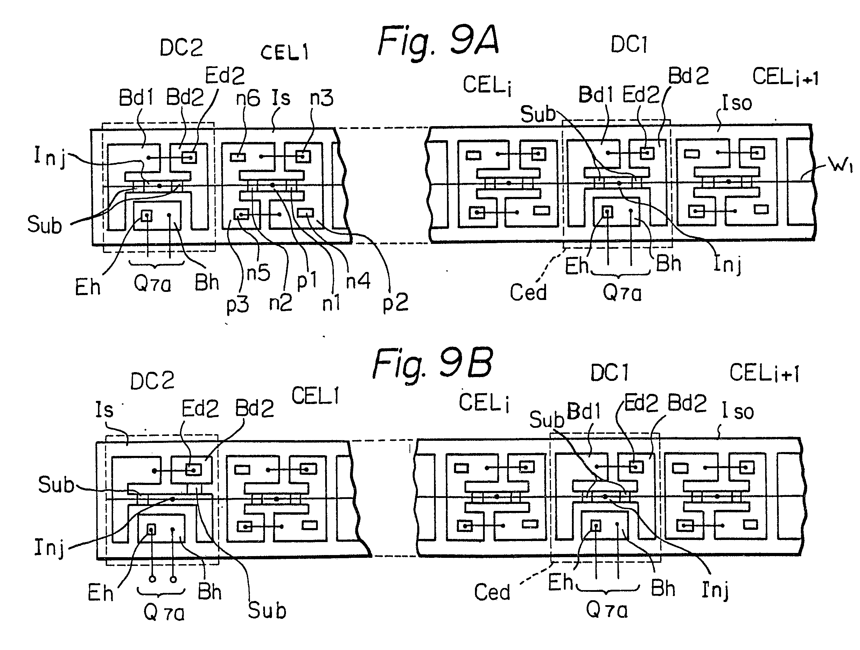

Fig. 9A illustrates a plan view of a pattern of the memory array when the dummy cells $DC_1$ and $DC_2$ are formed by using the dummy cell shown in Fig. 7A. Fig. 9B illustrates a plan view of a pattern of the memory array when the dummy cell $DC_1$ has a pattern shown in Fig. 7A and the dummy cell $DC_2$ has a pattern shown in Fig. 7B. Referring to Figs. 9A and 9B, $W_1$ illustrates a word line, $CEL_1$, $CEL_i$, $CEL_{i+1}$ illustrate memory cells, $p_1$ illustrates a p type region which forms a common emitter of the transistor $Q_1$ and $Q_2$ in the memory cell, $n_1$ and $n_2$ illustrate n type regions of the semiconductor layer which form the bases of the transistors $Q_1$ and $Q_2$, $p_2$ and $p_3$ illustrate p type

regions which form collectors of the transistors $Q_1$ and $Q_2$ and the bases of the transistors $Q_3$, $Q_4$, $Q_5$ and $Q_6$, $n_3$ illustrates an n type region which forms a collector of the transistor $Q_4$, $n_4$ illustrates an n type region which forms an emitter of the transistor $Q_6$, $n_5$ illustrates an n type region which forms a collector of the transistor $Q_3$, and $n_6$ illustrates an n type region which forms an emitter of the transistor $Q_5$. $Q_{7a}$ is the hold current supply transistor, having emitter Eh and base Bh.

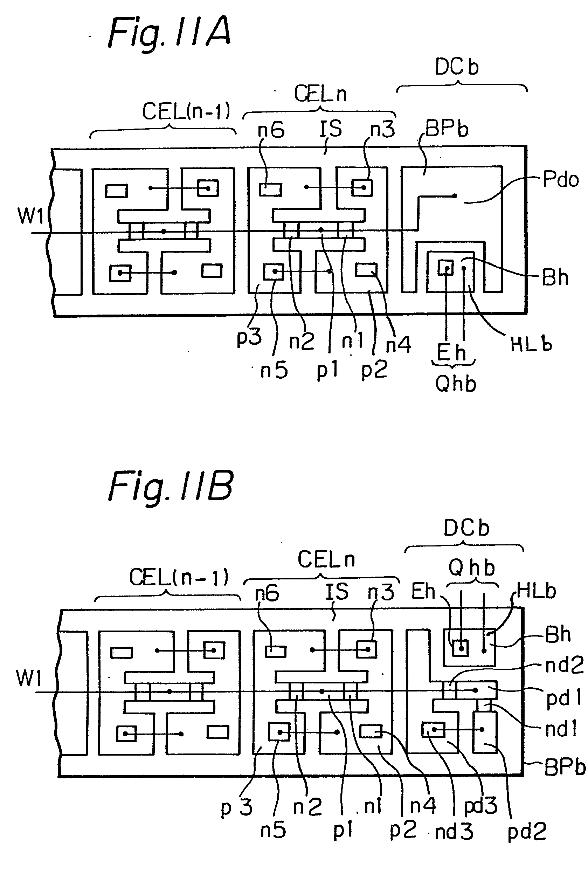

Fig. 10 illustrates an equivalent circuit of another embodiment of the memory array according to the present invention. Referring to Fig. 10, $CEL_1$, ..., $CEL_n$ illustrate memory cells which are illustrated by an equivalent circuit, $BP_a$ and $BP_b$ illustrate shunt circuits, $HL_a$ and $HL_b$ illustrate hold circuits, $Q_{ha}$ and $Q_{hb}$ illustrate transistors for supplying the hold current, and Rh illustrates a resistance due to the semiconductor layer which corresponds to the word line W— shown in Fig. 1A and Fig. 2.

Fig. 11A illustrates a pattern of one embodiment of the memory array shown in Fig. 10. Referring to Fig. 11A, IS illustrates a separate region, $BP_b$ illustrates a shunt circuit, $HL_b$ illustrates a hold circuit, $DC_b$ illustrates a dummy cell, $W_1$ illustrates a word line, $CEL_n$, and $CEL_{n-1}$ illustrate memory cells, $p_1$ illustrates a p type region which forms a common emitter of the transistor $Q_1$ and $Q_2$ in the memory cell, $n_1$ and $n_2$ illustrate n type regions of the semiconductor layer which form the bases of the transistors $Q_1$ and $Q_2$, $p_2$ and $p_3$ illustrate p type regions which form collectors of the transistors $Q_1$ and $Q_2$ and the bases of the transistors $Q_3$, $Q_4$, $Q_5$ and $Q_6$, $n_3$ illustrates an n type region which forms a collector of the transistor $Q_4$, $n_4$ illustrates an n type region which forms an emitter of the transistor $Q_6$, $n_5$ illustrates an n type region which forms a collector of the transistor $Q_3$, and $n_6$ illustrates an n type region which forms an emitter of the transistor $Q_5$.

A region pdo in the shunt circuit $BP_b$ is a p type region and this region is connected to the word line $W_1$ and forms a common emitter region of the injector transistor. This region pdo corresponds to the p type region $p_1$ in the memory cell. A region Eh in the hold circuit $HL_b$ is an n type region which forms an emitter of the transistor $Qh_b$ and a region Bh is a p type region which forms a base of the transistor $Qh_b$.

The shunt circuit $BP_a$ and $BP_b$ are formed by one injector in each, and the hold circuits $HL_a$ and $HL_b$ are formed by one transistor, so that the area of the dummy cell $DC_b$ formed by the shunt circuit $BP_a$ or $BP_b$ and the hold circuit $HL_a$ or $HL_b$ is smaller than the area of each memory cell. Therefore, the increase of the total area by distributing the dummy cells is very small, the equalization of the hold current in each cell can be obtained and the increase of the write threshold can be prevented. Also, the decrease of the integration density is very small.

Fig. 11B illustrates a pattern of another embodiment of the memory array shown in Fig. 10. Referring to Fig. 11B, the same symbols used in Fig. 11A illustrate the same elements. Further, referring to Fig. 11B, a shunt circuit $BP_b$ includes a p type region pd, which corresponds to the emitters of the transistors $Q_1$ and $Q_2$ connected to the word line $W_1$, a p type region $pd_2$ which corresponds to the collector of the transistor $Q_1$ and the base of the transistor $Q_4$, a p type region $pd_3$ which corresponds to the base of the transistor $Q_3$ and an n type region $nd_3$ which corresponds to the collector of the transistor $Q_3$.

Also in the embodiment shown in Fig. 11B, the area of the dummy cell which is formed by the shunt circuit $BP_a$ or $BP_b$ and the hold circuit $HL_a$ or $HL_b$ is smaller than that of the memory cell, and the affect to the integration density is very small.

As explained in detail above, according to the present invention, the increase of the write threshold current due to the deviation of the hold current, which occurrs when the memory cell array is formed by the integrated injection logic memory cells, can be removed by distributing the hold current supply transistors in the memory cell array. Therefore, the increase of the write threshold circuit can be obviated by combining the dummy cells, regardless of the position of the memory cell which is selected. Therefore, the increase of the write pulse width can be obviated and, as a whole, the characteristics of the random access memory can be improved. Further the density of the integration can be increased by making the dummy cell and the hold current supply transistor in the area smaller than the one bit area of the memory cell. because the dummy cell is not necessary to rewrite or to read out the information and therefore at least two transistors can be omitted.

Our co-pending European patent application No. 79300757.6 (published as 0005 601) describes and claims the provision of dummy cells at each end of each line of a memory cell array, the dummy cells shunting a part of the write current flowing when an integrated injection logic memory cell near the dummy cell is selected. Our co-pending European patent application 79301092.7 (No. 0006 702) describes and claims the provision of current sources at each end of a word line formed by a layer buried in the semiconductor bulk.

**Claims**

1. A semiconductor integrated circuit device including a memory cell array which is formed by integrated injection logic memory cells arranged in rows each having a pair of word lines (W + , W − , Fig. 1A) crossed by pairs of bit lines (BØ, B1), the integrated injection logic memory cells each receiving a hold current via the word lines and comprising a pair of first and second transistors ($Q_1$, $Q_2$) of a first conduction type which have a common emitter forming an injector; a pair of third and fourth transistors ($Q_3$, $Q_4$) of a second conduction type each of which has a collector connected to a collector of the first and second transistors respectively, the injector being connected to the first of a pair of word lines (W+), the third transistor having a base which is connected to the collector of the fourth transistor, the fourth transistor having a base which is connected to the collector of the third transistor, and the first and second transistors ($Q_1$, $Q_2$) having bases which are connected to emitters of the third and fourth transistors ($Q_3$, $Q_4$) and to the second of the pair of word lines (W−); a pair of fifth and sixth transistors ($Q_5$, $Q_6$) of the second conduction type which have bases connected to the bases of the third and fourth transistors respectively and which have collectors connected to the second of the pair of word lines (W−), the fifth and sixth transistors having emitters connected to the first and second of a pair of bit lines (BØ, B1) respectively; characterized in that dummy cells (DC, Fig. 9) are connected between the pair of word lines (W+, W−) in each row, each dummy cell having a shunt portion which shunts part of the write current when a memory cell in its row is written into, the amount of current shunted being greatest when the memory cell ($CEL_i$) written into is immediately adjacent the dummy cell (DC1), and further having a current supply transistor (Q7a) which supplies a part of the hold current to the memory cells of the row, the dummy cells thus reducing the dependency of the magnitude of the write and hold currents in a memory cell on its position in a row.

2. A semiconductor integrated circuit device according to claim 1, wherein the shunt circuit in a dummy cell (DC1, Fig. 9A) has an injector (Inj) which has the same area as that of the injector of the integrated injection logic cell (CELi).

3. A semiconductor integrated circuit device according to claim 1, wherein the shunt circuit in the dummy cells (DC2, Fig. 9B) has an injector (Inj) having a larger area than that of the injector of the integrated injection logic memory cell (CEL1).

4. A semiconductor integrated circuit device according to claim 1, wherein the shunt circuit in the dummy cells is formed by a diode (Fig. 7D; DCb, Fig. 11A) which is connected between the first word line and the second word line.

5. A semiconductor integrated circuit device according to claim 2 or 3, wherein the shunt circuit in the dummy cells (DC1, Fig. 9) comprises a first region (Inj) of a first conduction type which corresponds to the emitters of the first and second transistors, first and second regions (Sub) of a second conduction type which correspond to the bases of the first and second transistors, respectively, a second region (Bd1) of a first conduction type which corresponds to the collector of the first transistor, a third region (Bd2) of a first conduction type which corresponds to the collector of the second transistor and the base of the third transistor.

6. A semiconductor integrated circuit device according to claim 5, wherein the dummy cells each further comprise a third region (Ed2) of a second conduction type which corresponds to the collector of the third transistor, the collector (Bd1) of the first transistor being connected to the collector of the third transistor.

7. A semiconductor integrated circuit device according to claim 1, wherein an injector area (Inj) of the shunt circuit included in the dummy cells (DC2, Fig. 9B) arranged at each end of each line of the memory cell array is larger than that of the shunt circuit included in the dummy cells (DC1) arranged in the midst of each line of the memory cell array.

**Revendications**

1. Dispositif à circuit intégré à semi-conducteur comportant un ensemble de cellules de mémorisation qui est formé par des cellules de mémorisation à logique à injection intégrée disposées en rangées possédant chacune une paire de lignes de mots (W+, W—, figure 1A) croisées par des paires de lignes de bits (B∅, B1), les cellules de mémorisation à logique à injection intégrée recevant chacune un courant de maintien via les lignes de mots et comprenant une paire de premier et deuxième transistors ($Q_1$, $Q_2$) d'un premier type de conduction qui possèdent un émetteur commun formant un injecteur; une paire de troisième et quatrième transistors ($Q_3$, $Q_4$) d'un deuxième type de conduction qui possèdent chacun un collecteur connecté à un collecteur des premier et deuxième transistors respectivement, l'injecteur étant connecté à la première d'une paire de lignes de mots (W+), le troisième transistor possédant une base qui est connectée au collecteur du quatrième transistor, le quatrième transistor possédant une base qui est connectée au collecteur du troisième transistor, et les premier et deuxième transistors ($Q_1$, $Q_2$) possédant des bases qui sont connectées à des émetteurs des troisième et quatrième transistors ($Q_3$, $Q_4$) et à la deuxième de la paire de lignes de mots (W—); une paire de cinquième et sixième transistors ($Q_5$, $Q_6$) du deuxième type de conduction qui possèdent des bases respectivement connectées aux bases des troisième et quatrième transistors et qui possèdent des collecteurs connectés à la deuxième de la paire de lignes de mots (W—), les cinquième et sixième transistors possédant des émetteurs respectivement connectés à la première et à la deuxième d'une paire de lignes de bits (B∅, B1); caractérisé en ce que des cellules fictives (DC, figure 9) sont connectées entre la paire de lignes de mots (W+, W—) dans chaque rangée, chaque cellule fictive possédant une partie de shunt qui shunte une partie du courant d'écriture lorsqu'une cellule de mémorisation se trouvant dans sa rangée est sollicitée en écriture, la quantité, de courant shunté étant plus grands lorsque la cellule de mémorisation (CELi) sollicitée en écriture est immédiatement adjacente à la cellule fictive (DC1), et possédant en outre un transistor d'alimentation en courant (Q7a) qui fournit une partie du courant de maintien aux cellules de mémorisation de la rangée, les cellules fictives réduisant donc la dépendance de l'amplitude des courants d'écriture et de maintien dans une cellule de mémorisation en fonction de sa position dans une rangée.

2. Dispositif à circuit intégré à semi-conducteur selon la revendication 1, où le circuit de shunt se trouvant dans une cellule fictive (DC1, figure 9A) possède un injecteur (Inj) qui a la même aire que l'injecteur de la cellule à logique à injection intégrée (CELi).

3. Dispositif à circuit intégré à semi-conducteur selon la revendication 1, où le circuit de shunt se trouvent dans les cellules de mémorisation (DC2, figure 9B) possède un injecteur (Inj) ayant une aire plus grande que celle de l'injecteur de la cellule de mémorisation à logique à injection intégrée (CEL1).

4. Dispositif à circuit intégré à semi-conducteur selon la revendication 1, où le circuit de shunt se trouvant dans les cellules fictives est formé par une diode (figure 7D; DCb, figure 11A) qui est connectée entre la première ligne de mots et la deuxième ligne de mots.

5. Dispositif à circuit intégré à semi-conducteur selon la revendication 2 ou 3, où le circuit de shunt se trouvant dans les cellules fictives (DC1, figure 9) comprend une première région (Inj) d'une premier type de conduction qui correspond aux émetteurs des premier et deuxième transistors, une première et une deuxième région (Sub) d'un deuxième type de conduction qui correspond aux bases des premier et deuxième transistors respectivement, une deuxième région (Bd1) d'un premier type de conduction qui correspond au collecteur du premier transistor, une troisième région (Bd2) d'un premier type de conduction qui correspond au collecteur de deuxième transistor et à la base du troisième transistor.

6. Dispositif à circuit intégré à semi-conducteur selon la revendication 5, où les cellules fictives comprennent en outre chacune une troisième région (Ed2) d'un deuxième type de conduction qui correspond au collecteur du troisième transistor, le collecteur (Bd1) du premier transistor étant connecté au collecteur du troisième transistor.

7. Dispositif à circuit intégré à semi-conducteur selon la revendication 1, où une aire d'injecteur (Inj) du circuit de shunt inclus dans les cellules fictives (DC2, figure 9B) disposées à chaque extrémité de chaque ligne de l'ensemble de cellules de mémorisation est plus grande que celle du circuit de shunt inclus dans les cellules fictives (DC1) disposées à la moitié de chaque ligne de l'ensemble de cellules de mémorisation.

## Patentansprüche

1. Integrierte Halbleiterschaltungsanordnung mit einer Speicherzellenanordnung, welche durch integrierte Injektions-Logikspeicherzellen gebildet ist, welche in Reihen angeordnet sind, die jeweils ein Paar von Wortleitungen (W+, W—, Fig. 1A) haben, welche über Kreuz mit einem Paar von Bit-Leitungen (BØ, B1) angeordnet sind, wobei die integrierten Injecktions-Logikspeicherzellen jeweils über Wortleitungen einen Haltestrom empfagen und einen ersten und einen zweiten Transistor (Q1, Q2) von einem ersten Leitungstyp umfassen, welche einen gemeinsamen Emitter haben, der einen Injektor bildet, mit einem dritten und einem vierten Transistor (Q3, Q4) vom zweiten Leitfähigkeitstyp, deren Kollektor jeweils mit einem Kollektor des ersten bzw. des zweiten Transistors verbunden ist, wobei der Injektor mit der ersten Wortleitung (W+), die Basis des dritten Transistors mit dem Kollektor des vierten Transistors, die Basis des vierten Transistors mit dem Kollektor des dritten Transistors und die Basen des ersten und das zweiten Transistors (Q1, Q2) mit den Emittern des dritten und vierten Transistors (Q3, Q4) und mit der zweiten Wortleitung (W—) verbunden sind, mit einem fünften und sechsten Transistor (Q5, Q6) vom zweiten Leitfähigkeitstyp, deren Basen mit den Basen des dritten bzw. vierten Transistors und deren Kollektoren mit der zweiten Wortleitung (W—) verbunden sind, während die Emitter des fünften und sechsten Transistors mit der ersten bzw. mit der zweiten Bitleitung (BØ, B1) verbunden sind, dadurch gekennzeichnet, daß blinde Speicherzellen (DC, Fig. 9) zwischen die beiden Wortleitungen (W+, W—) in jeder Reihe geschaltet sind, daß jede blinde Zelle einen Nebenschlußabschnitt hat, welcher einen Teil des Schreibstroms nebenschließt, wenn eine Speicherzelle in ihrer Reihe beschrieben wird, wobei die Menge des nebengeschlossenen Stroms am größten ist, wenn die Speicherzelle (CELi), die beschrieben wird, unmittelbar neben der blinden Zelle (DC1) angeordnet ist, und daß ein Stromversorgungstransistor (Q7) vorgesehen ist, welcher einen Teil des Haltestroms zu den Speicherzellen der Reihe liefert, wodurch die blinde Zelle die Abhängigkeit von der Größe des Schreib- und des Haltestroms in einer Speicherzelle in ihrer Position in einer Reihe reduziert.

2. Integrierte Halbleiterschaltungsanordnung nach Anspruch 1, dadurch gekennzeichnet, daß die Nebenschlußschaltung in einer blinden Zelle (DC1, Fig. 9a) einen Injektor (Inj) umfaßt, welcher dieselbe Fläche wei der Injektor der integrierten Injektions-Logikspeicherzelle (CEL1) hat.

3. Integrierte Halbleiterschaltungsanordnung nach Anspruch 1, dadurch gekennzeichnet, daß die Nebenschlußschaltung in den blinden Zellen (DC2, Fig. 9b) einen Injektor (Inj) umfaßt, welcher einer größere Fläche als der Injektor der integrierten Injektions-Logikspeicherzelle (CEL1) hat.

4. Integrierte Halbleiterschaltungsanordnung nach Anspruch 1, dadurch gekennzeichnet, daß die Nebenschlußschaltung in den blinden Zellen von einer Diode (Fig. 7D; DCb, Fig 11A) gebildet wird, welche zwischen die erste und die zweite Wortleitung geschaltet ist.

5. Integrierte Halbleiterschaltungsanordnung nach Anspruch 2 oder 3, dadurch gekennzeichnet, daß die Nebenschlußschaltung in den blinden Zellen (DC1, Fig. 9) einen ersten Bereich (Inj) vom ersten Leitfähigkeitstyp umfaßt, welcher dem Emittern des ersten und des zweiten Transistors entspricht, und erste und zweite Bereiche (Sub) eines zweiten Leitfähig keitstyps, welche den Basen des ersten bzw. zweiten Transistors entsprechend, und einen zweiten Bereich (Bd1) von ersten Leitfähigkeitstyp, welcher dem Kollektor des ersten Transistors entspricht und eine dritten Bereich (Bd2) von einem ersten leitfähig keitstyp, welcher dem Kollektor des zweiten Transistor und der Basis des dritten Transistors entspricht.

6. Integrierte Halbeiterschaltungsanordnung nach Anspruch 5, dadurch gekennzeichnet, daß die blinden Zellen jeweils ferner einen dritten Bereich (Ed2) vom zweiten Leitfähigkeitstyp umfassen, welcher dem Kollektor des dritten Transistors entspricht, und daß der Kollektor (Bd1) des ersten Transistors mit dem Kollektor des dritten Transistors verbunden ist.

7. Integrierte Halbleiterschaltungsanordnung nach Anspruch 1, dadurch gekennzeichnet, daß der Injektorbereich (Inj) der Nebenschlußschaltung, welche in den blinden Zellen (DC2, Fig. 9B) enthalten ist, die an jedem Ende jeder Zeile der Speicherzellenanordnung angeordnet sind, größer als derjenige von der Nebenschlußschaltung ist, welche in den blinden Zellen (DC1) enthalten ist, die in der Mitte jeder Zeile der Speicherzellenanordnung angeordnet sind.

Fig. 1A

Fig. 1B

Fig. 1C

Fig. 2

# Fig. 3

# Fig. 4A

# Fig. 4B

# Fig. 5A

Ce1 Ce2 ------- Cei          Cei+1  Cei+2

| $I_H$ | DC | DC | | | | | | | DC | DC | $I_H$ | DC | DC | | | | | | | | |
|---|---|---|---|---|---|---|---|---|---|---|---|---|---|---|---|---|---|---|---|---|

# Fig. 5B

(a)

$Cel_i$     $I inj$          $Cel_{i+1}$          $W^+$

$Rh$

$W^-$

$B_0$          $B_1$  $V_E$  $V_B$  $B_0'$          $B_1'$

(b)

$Cel_{i-1}$  $Cel_i$  $Cel_{i+1}$  $Cel_{i+2}$  $Cel_{i+3}$

$Rh$

$I_W$

# Fig. 5C

Ce1 Ce2 ------ Cei          Cei+1  Cei+2

| $I_H$ | DC | | | | | | | DC | $I_H$ | DC | | | | | | | | |
|---|---|---|---|---|---|---|---|---|---|---|---|---|---|---|---|---|---|---|

4

# Fig. 6A

# Fig. 6B

# Fig. 6C

# Fig. 7A

# Fig. 7B

# Fig. 7C

# Fig. 7D

# Fig. 8A

DC2

DC1

Fig.7B
Fig.7C
Fig.7D

Fig.7A

# Fig. 8B

DC2

DC1

Iw

Iw'

Iw"

# Fig. 10

CEL1  CEL2

CEL(n-1) CELn

BPa

Rh    Rh   Rh

Rh   Rh   Rh

BPb

HLa

HLb

Iw

Qhb

Qha

Fig. 9A

Fig. 9B

0 006 753

# Fig. 11A

# Fig. 11B